## Europäisches Patentamt

## European Patent Office

## Office européen des brevets

(11) Publication number: **0 020 648**

**B1**

(12) **EUROPEAN PATENT SPECIFICATION**

(45) Date of publication of patent specification: **15.05.85**

(51) Int. Cl.⁴: **G 11 C 17/00**

(21) Application number: **79901649.8**

(22) Date of filing: **16.11.79**

(86) International application number:
**PCT/US79/00989**

(87) International publication number:
**WO 80/01119 29.05.80 Gazette 80/12**

(54) **Read-only memory with field effect transistors having variable conductance value channels.**

(30) Priority: **20.11.78 US 962572**

(43) Date of publication of application:
**07.01.81 Bulletin 81/01**

(45) Publication of the grant of the patent:
**15.05.85 Bulletin 85/20**

(84) Designated Contracting States:
**DE GB NL**

(56) References cited:
**EP-A-0 006 167**
**US-A-3 656 117**
**US-A-4 054 864**
**US-A-4 085 459**

**IBM TECHNICAL DISCLOSURE BULLETIN, vol. 14, no. 5, October 1971, pages 1429-1430, New York, U.S.A., U. BAITINGER et al.: "IGFET read-only memory"**
**IBM TECHNICAL DISCLOSURE BULLETIN, vol. 19, no. 6, November 1976, pages 2262-2265, New York, U.S.A., V.L. RIDEOUT: "Logic arrays with polysilicon gate lines"**

(73) Proprietor: **NCR Corporation**
**World Headquarters**
**Dayton, Ohio 45479 (US)**

(72) Inventor: **CRAYCRAFT, Donald Gregory**
**9460 Atchison Road**
**Spring Valley, OH 45370 (US)**

(74) Representative: **Robinson, Robert George**
**International Patent Department NCR Limited**
**206 Marylebone Road**
**London NW1 6LY (GB)**

(56) References cited:
**IBM TECHNICAL DISCLOSURE BULLETIN, vol. 13, no. 1, June 1970, pages 16-17, New York, U.S.A., N.E. BEVERLY et al.: "Read-only memory for table loop-up"**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

Technical field

This invention relates to read-only memories of the kind including addressing means, a plurality of field effect transistors arranged to represent predetermined digital information, and output means.

Background art

A read-only memory of the kind specified is known from the publication "A User's Handbook of Semi-conductor Memories" by E. R. Hnatek (John Wiley and Sons, New York, 1977) pages 194—196. In this known memory a thin oxide layer over the channel area of an MOS transistor separates the channel from the gate electrode; if the layer is thick the gate will not work. Thus, stored logic "1"s and logic "0"s in the memory cells of the memory are established by thin and thick regions on the oxide.

Attention is also directed to U.S.—A—4,054,864 (Audaire s.o) which discloses an arrangement for storing analog signals. In this known arrangement the threshold voltages of MIIS transistors included in "memory cores" are utilized to store analog signals representing samples of a function h which are fed to a "brigade bucket" chain. Thus, the cited arrangement utilizes the capability of alterable threshold transistors to store analog signal values presented thereto.

In connection with Article 54 (3) EPC, attention is directed to EP—A—0 006 167 (IBM) which discloses a read-only memory including a plurality of field effect transistors, the channel of each of which may have one out of four possible threshold values determined by the ion-implantation at the time of manufacture.

Disclosure of the invention

It is an object of the present invention to provide a read-only memory of the kind specified which has a high information storage density.

Therefore, according to the present invention, there is provided a read-only memory of the kind specified, characterised in that the channels of said field effect transistors have predetermined conductance values determined by respective predetermined cross-sectional areas of the channels of said transistors and selected from at least three possible conductance values, whereby in response to address signals applied to said addressing means the addressed transistor or transistors provide a sense signal determined by the conductance value or values associated with the addressed transistor or transistors, said sense signal being applied in operation to said output means.

It will be appreciated that a read-only memory according to the invention has the advantage that a high information storage density can be achieved since each field effect transistor has the capability of storing more information than a single binary bit of information.

According to a preferred embodiment of the invention, the predetermined conductance values are selected from $2^n$ possible conductance values (n>1). This has the advantage that each field effect transistor has the capability of storing n binary bits of information, as will be explained hereinafter.

Conveniently, the cross-sectional area may be determined by the effective channel width, which in turn may be determined by the width of the channel-defining source and drain diffusions.

Brief description of the drawings

One embodiment of the invention will now be described by way of example with reference to the accompanying drawings, in which:

Fig. 1 is a schematic representation of the layered components of a ROM memory which stores two bits of information per cell;

Figs. 2 and 3 are cross-sectional views taken along lines II—II and III—III of Fig. 1, showing the varied channel geometry which provides the electrical outputs characteristic of the possible combinations of two bits;

Fig. 4 is a cross-sectional view taken along line IV—IV of Fig. 1 parallel to the channel width;

Fig. 5 is a block diagram of a ROM array which utilizes FET memory cells embodying the principles of the present invention;

Fig. 6 is a partial, schematic representation of Fig. 5 showing the arrangement for applying read voltages to a single FET memory cell; and

Fig. 7 is a chart showing the relative magnitudes of the reference voltages and FET output voltages for the arrangements of Table I and Figs. 5 and 6.

Best mode for carrying out the invention

The principles utilized in the embodiment described herein for binary information storage, as an example, will first be discussed. There are $2^n$ different permutations or arrangements of bits taken n at a time. Tables I and II show the possible arrangements for n=2 and n=3. The channel width of the FET memory cell is conveniently set to one of $2^n$ predetermined widths with corresponding FET output values which represent the possible arrangements. As shown, an ordered sequence of these output values is chosen to arbitrarily represent the sequence of 1, 2... $2^n$ possible arrangements of bits taken n at a time. Note that the output values, not the physical channel dimensions per se, represent the binary sequence. Thus, rather than merely using, e.g., $w_1=0$; $w_2=1/3\ w_4$; $w_3=2/3\ w_4$ in Table I, the *physical* channel widths are those which provide an output sequence such as $V_1=0$; $V_2=1/3\ V_4$; $V_3=2/3\ V_4$; $V_4$.

In Table II, the physical channel widths are those necessary to provide outputs such as $V_1=0$; $V_2=1/7\ V_8$; $V_3=2/7\ V_8$; $V_4=3/7\ V_8$; $V_5=4/7\ V_8$; $V_6=5/7\ V_8$; $V_7=6/7\ V_8$; $V_8$. As described below, an array of $2^n-1$ sense amplifiers can be used to read the stored binary data from any number of such FET memory cells, limited only by the operational characteristics, such as the sensitivity of the sense amplifiers, and by the circuit design.

Table I
(n=2)

| Combination no. | Bits | | FET Channel width | FET output | Sense amplifier output | | |
|:---:|:---:|:---:|:---:|:---:|:---:|:---:|:---:|
| | $B_0$ | $B_1$ | | | 12 | 23 | 34 |
| 1 | 0 | 0 | $w_1$ | $V_1$ | 0 | 0 | 0 |
| 2 | 0 | 1 | $w_2$ | $V_2$ | 1 | 0 | 0 |
| 3 | 1 | 0 | $w_3$ | $V_3$ | 1 | 1 | 0 |
| $4(2^n)$ | 1 | 1 | $w_4$ | $V_4$ | 1 | 1 | 1 |

Table II
(n=3)

| Combination no. | Bits | | | FET Channel width | FET output | Sense amplifier output | | | | | | |
|:---:|:---:|:---:|:---:|:---:|:---:|:---:|:---:|:---:|:---:|:---:|:---:|:---:|
| | $B_0$ | $B_1$ | $B_2$ | | | 12 | 23 | 34 | 45 | 56 | 67 | 78 |
| 1 | 0 | 0 | 0 | $w_1$ | $V_1$ | 0 | 0 | 0 | 0 | 0 | 0 | 0 |
| 2 | 1 | 0 | 0 | $w_2$ | $V_2$ | 1 | 0 | 0 | 0 | 0 | 0 | 0 |
| 3 | 0 | 1 | 0 | $w_3$ | $V_3$ | 1 | 1 | 0 | 0 | 0 | 0 | 0 |
| 4 | 1 | 1 | 0 | $w_4$ | $V_4$ | 1 | 1 | 1 | 0 | 0 | 0 | 0 |
| 5 | 0 | 0 | 1 | $w_5$ | $V_5$ | 1 | 1 | 1 | 1 | 0 | 0 | 0 |
| 6 | 1 | 0 | 1 | $w_6$ | $V_6$ | 1 | 1 | 1 | 1 | 1 | 0 | 0 |
| 7 | 0 | 1 | 1 | $w_7$ | $V_7$ | 1 | 1 | 1 | 1 | 1 | 1 | 0 |
| $8(2^n)$ | 1 | 1 | 1 | $w_8$ | $V_8$ | 1 | 1 | 1 | 1 | 1 | 1 | 1 |

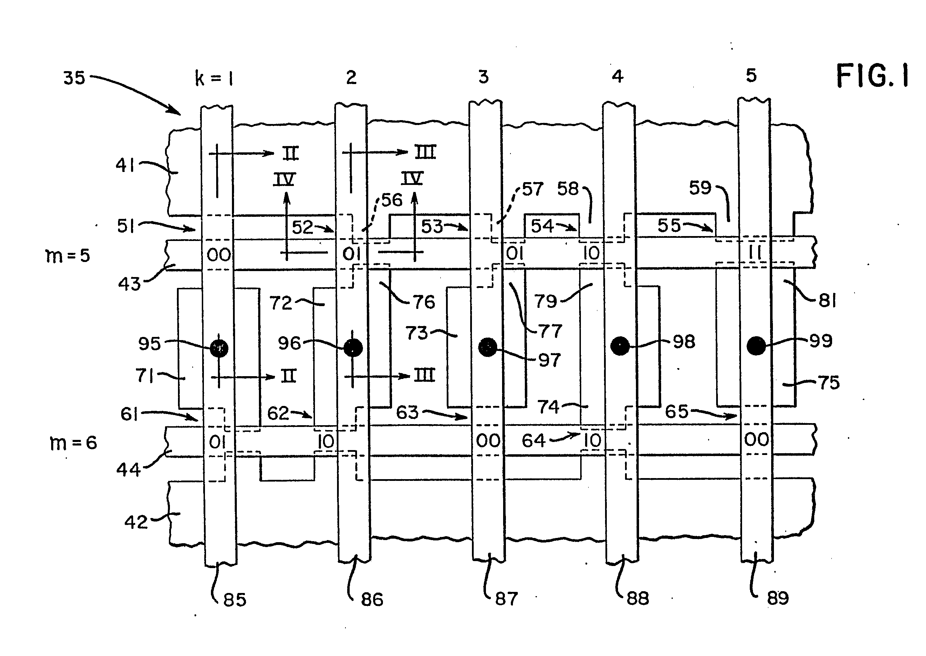

Fig. 1 is a schematic plan view of a portion of a ROM 35 which contains an m×k, row by column matrix of FET cells. The cells of the matrix are designated 51—55 and 61—65, where the first number of each numerical designation is the row and the second is the column. The figure identifies the stored binary information for each cell location.

The cell design of ROM 35 is conventional, except for the varied widths of the diffusions which define the FET sources and drains. Because the channel conductance and the resulting channel current or voltage output are determined by the effective channel width provided by these diffusions, the binary state of each FET can be determined from the magnitude of the channel current or voltage. Thus, FET 51, which does not have a source-forming diffusion or a drain-forming diffusion, has no channel and represents binary 00. (Unless specified otherwise, "diffused" and "diffusion" include doped regions formed by ion implantation techniques as well as by diffusion techniques). For FETs 52—55, projections 56—59 from diffusion stripe 41 form the drains, and the sources are formed by the upper ends 76, 77, 79, 81 of diffusion areas 72—75. The widths $w_2$; $w_2$; $w_3$; and $w_4$ of the channel-defining diffusions 56 and 76; 57 and 77; 58 and 79; and 59 and 81 are tailored as described previously so that the outputs of FETs 52—55 represent binary 01; 01; 10; and 11 in accordance with Table I. Although row 6 will not be described in detail, the channel widths provided by drain-forming ends of diffusions 71—75 and source-forming projections of diffusion stripe 42 provide binary 01, 10, 00, 10, and 00 for FETs 61—65, respectively, in accordance with Table I.

Control voltages can be applied to the drains of cell row 5 via electrical contact (not shown) which can be made at one end of the diffusion stripe 41. Control voltages can be applied to the source diffusions via metal column lines 85—89. Polysilicon line 43 forms the gate electrode for each of the transistors in row 5. Electrical contact is made at one end of this polysilicon line for providing control signals to the gates. Other electrical connections, such as to the ROM circuit substrate (not shown) of course can be provided as

3

necessary. The gate voltage controls the conductive state of the channel between the source and drain, i.e., turns the FET on or off, while voltages can be applied to the source, drain, and substrate to control, e.g., the threshold voltage and the magnitude of the drain-to-source current.

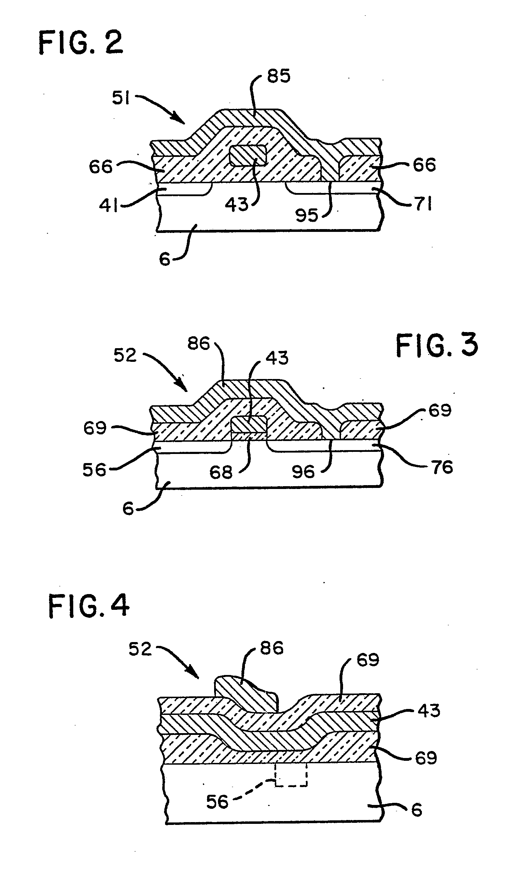

The construction of the FETs of Fig. 1 is further clarified in Figs. 2—4. Fig. 2 is a cross-sectional view of FET 51, which has no channel. Fig. 3 is a cross-sectional view of transistor 52, and also is representative of all the row 5 FETs 52—55, which have an effective channel width greater than 0 (i.e. $w_2$, $w_3$ or $w_4$). Fig. 4 is a cross-sectional view of FET 52 taken within the channel looking perpendicular to the channel width. It should be noted that the memory array of Fig. 1 is constructed using conventional, well-known process techniques. The method of construction does not form a part of this invention and will not be explained here.

Referring further to Fig. 2, the absence of source and drain-defining projections associated with the diffusions 41 and 71 in substrate 6 precludes the formation of a channel beneath the section of the polysilicon gate stripe 43 associated with FET 51. Also, the gate electrode 43 is surrounded by thick silicon oxide layer 66, which precludes the formation of a channel under normal operating conditions.

Referring now to Figs. 3 and 4, FET 52 comprises source 56 and drain 76 which extend from the diffused regions 41 and 72, respectively. A gate dielectric layer 68, typically of silicon dioxide, extends over the channel region between the source and drain and has the polysilicon gate electrode 43 formed thereon. A thick silicon oxide layer 69 isolates the gate electrode 43 from the metal column line 86, which contacts the source-forming diffused region 72 at 82.

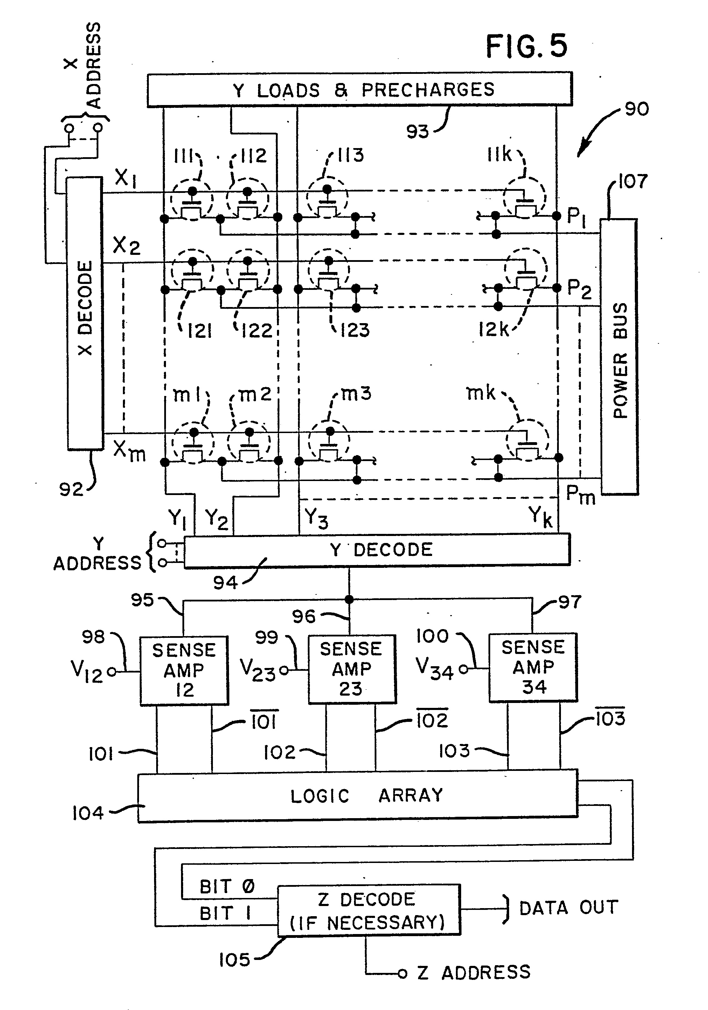

Fig. 5 is a block diagram of the organization of an m×k ROM array 90 which utilizes the ROM cell design of Fig. 1. The rectangular array 90 stores two bits (n=2) per memory cell location. This is done using one of four FET channel widths ($2^n$=4) in each memory cell location and sensing the FET output voltage using three ($2^n$-1=3) differential sense amplifiers. The FET memory cells are designated 111, 112, 113, ...mk. The X lines correspond to polysilicon gate electrode lines such as line 43 of Fig. 1. The P and Y lines correspond respectively, to metal contact lines for the source, such as 85—89, and to drain diffusion stripes, such as 41 and 42, all of Fig. 1.

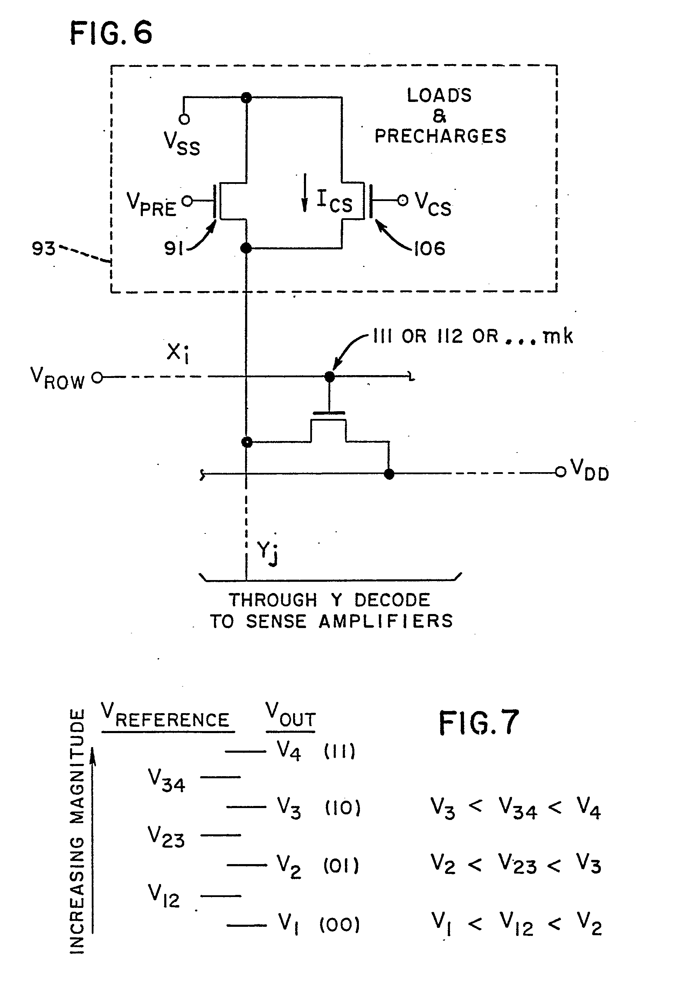

The array 90 is prepared for reading the stored binary digital values by first precharging all the Y lines and sense amplifiers. Current source FET 106 can be on at all times. Referring to Figs. 5 and 6, voltage $V_{pre}$ is driven high to turn on FET 91 and precharge the individual $Y_j$ lines (j=1, 2, ...k) to $V_{ss}$. Then $V_{pre}$ goes low to turn off FET 91 and X decode 92 selects a row line $X_i$ (i=1, ...m) and drives the selected row line to a "1". That is, $V_{row}$ is applied to the selected row $X_i$ so that all the transistors therein are turned on (unless they are binary 00) and drive into the Y loads 93. The transistors generate an output voltage on each $Y_j$ line which is determined by the threshold voltage at $I_{cs}$ of each memory FET. Stated differently, the output voltage is determined by the voltage division between the memory FET and current ($I_{cs}$) source device 106. Each output voltage is one of the four possible output voltages $V_1$—$V_4$ shown in Table I.

To decode the output, a $Y_j$ line is selected by the Y decode 94 and drives through the Y decode 94 and into a first input terminal 95, 96, 97 of each sense amplifier. The differential sense amplifiers compare the output voltage against three reference voltages $V_{12}$, $V_{23}$, and $V_{34}$, which are applied, respectively, to a second input terminal 98, 99, 100 of each sense amplifier. The reference voltages are between and, typically, are an average of the three pairs of adjacent FET output voltages (For example, $V_{12}$=$(V_1+V_2)/2$.) A sense amplifier provides an output signal if the voltage at the first input terminal exceeds the reference voltage. Referring to Figs. 5 and 7, the memory cell output voltage $V_1$, $V_2$, $V_3$, or $V_4$ thus turns on none of the sense amplifiers ($V_1$), sense amplifier SA12 ($V_2$), two sense amplifiers SA12 and SA23 ($V_3$), or all three sense amplifiers SA12, SA23 and SA34 ($V_4$). The outputs at terminal pairs 101 and $\overline{101}$; 102 and $\overline{102}$; 103 and $\overline{103}$ of the three sense amplifiers are the inverse of one another and are provided as inputs to a logic array 104. The collective sense amplifier outputs control the operation of logic circuit 104, which generates the two bits of data associated with the particular channel width of the selected FET. See Table I. (The on and off states of the sense amplifiers are indicated respectively by "1" and "0" in the tables). These two bits of data can be used as parallel outputs or can be applied to a Z decode 105 which would then output a selected one of the data bits depending upon the value of the Z control signal.

The sense amplifiers, logic array and X, Y and Z decodes are of conventional design and need not be described in detail.

As an example of decoding a particular FET memory cell output, refer to Fig. 5 and assume that the channel width of FET 111 in array 90 is $w_3$. That is, the width of the channel of FET 111 is selected to provide an output $V_3$=2/3 $V_4$, which corresponds to bit combination 10, Table I. Upon application of $V_{row}$ to row $X_1$ as described above, this output $V_3$ is generated on line $Y_1$ and is applied via Y decode 94 to one of the input terminals 95, 96, 97 of each sense amplifier. Referring further to Fig. 5 and also to Fig. 7, $V_3$ is greater than the reference voltages $V_{12}$ and $V_{23}$ which are applied to sense amplifiers SA12 and SA23, respectively, but smaller than the reference voltage $V_{34}$ applied to sense amplifier SA34. Accordingly, SA12 and SA23, but not SA34, are turned on by $V_3$ and their collective outputs drive logic array 104 to generate the two bits 10.

As another example, if the channel width of FET 111 had been $w_2$ ($w_2$ is tailored to provide output $V_2$=1/3 $V_4$), only sense amplifier SA12 would be turned on by the output, and this single output would drive logic array 104 to generate the bits 01 associated with output $V_2$.

An NCR standard PDISG (p-channel dielectrically insulated silicon gate) ROM cell utilizes a cell size of 15 microns×23 microns (345 square microns) and provides a storage density of about 290,000 bits per square centimeter, excluding control circuitry. For this standard cell size, a two bit per cell, PDISG ROM array 90 provides storage of about 580,000 bits per square centimeter, excluding control circuitry. A maximum physical channel width $w_4=7.5$ microns is used. This dimension is an example only, for greater or lesser widths are available at the option of the circuit designer.

Although in the described embodiment the channel conductance is determined by the channel width, it should be understood that, more generally, the channel conductance can be determined by the channel cross-sectional area.

**Claims**

1. A read-only memory including addressing means, a plurality of field effect transistors arranged to represent predetermined digital information, and output means, characterized in that the channels of said field effect transistors (111, 112, ...mk) have predetermined conductance values determined by respective predetermined cross-sectional areas of the channels of said transistors (111 etc.) and selected from at least three possible conductance values, whereby in response to address signals applied to said addressing means the addressed transistor or transistors provide a sense signal determined by the conductance value or values associated with the addressed transistor or transistors, said sense signal being applied in operation to said output means (94, SA12 etc., 104, 105).

2. A read-only memory according to claim 1, characterized in that said predetermined conductance values are selected from $2^n$ possible conductance values (n>1).

3. A read-only memory according to claim 2, characterized in that said predetermined cross-sectional areas are determined by respective predetermined channel widths of said transistors (111 etc.), said channel widths corresponding to the widths of respective source and drain diffusions of said transistors.

4. A read only memory according to claim 3, characterized in that said output means includes: decoding means (94) coupled to said addressing means and responsive to said sense signal and to said address signals to provide a read signal representing the conductance value of a selected one of said transistors; and sensing means (SA12, SA23, SA34, 104) responsive to said read signal to provide a set of n binary signals representing the value of said read signal.

5. A read-only memory according to claim 4, wherein said sensing means includes $2^n-1$ sense amplifiers (SA12, SA23, SA34) adapted to compare said read signal with respective different reference levels and to provide respective comparison signals dependent on the relative magnitude of said read signal and said reference levels, and logic means (104) responsive in operation to said comparison signals to provide said n binary signals.

6. A read-only memory according to claim 5, characterized in that said output means includes a decoding device (105) coupled to said addressing means and responsive to said address signals to provide an output representing a selected one of said n binary signals.

7. A read-only memory according to any one of the preceding claims, characterized in that said sense signal is in the form of a voltage signal.

**Patentansprüche**

1. Nur-Lesen-Speicher mit Adressiermitteln, einer Vielzahl von Feldeffekttransistoren, die zur Darstellung vorbestimmter Informationen angeordnet sind, und Ausgangsmitteln, dadurch gekennzeichnet, daß die Kanäle der genannten Feldeffekttransistoren (111, 112 ...mk) vorbestimmte Leitfähigkeitswerte besitzen, die durch entsprechende vorbestimmte Querschnittsbereiche der Kanäle der genannten Transistoren (111 etc.) bestimmt werden und von zumindest drei möglichen Leitfähigkeitswerten ausgewählt sind, wodurch unter Ansprechen auf an Adressiermittel angelegt Adressiersignale der adressierte Transistor bzw. die adressierten Transistoren ein Lesesignal abgeben, welches durch den bzw. die Leitfähigkeitswerte bestimmt wird, welche dem bzw. den adressierten Transistoren zugeordnet sind, wobei das genannte Lesesignal im Betrieb an die genannten Ausgangsmittel (94, SA12 etc., 104, 105) angelegt wird.

2. Nur-Lesen-Speicher nach Anspruch 1, dadurch gekennzeichnet, daß die genannten vorbestimmten Leitfähigkeitswerte aus $2^n$ möglichen Leitfähigkeitswerten ausgewählt werden (n>1).

3. Nur-Lesen-Speicher nach Anspruch 2, dadurch gekennzeichnet, daß die genannten vorbestimmten Querschnittsbereiche durch entsprechende vorbestimmte Kanalbreiten der genannten Transistoren (111 etc.) bestimmt werden, wobei die Kanalbreiten den Breiten entsprechender Source- und Draindiffusionen der genannten Transistoren entsprechen.

4. Nur-Lesen-Speicher nach Anspruch 3, dadurch gekennzeichnet, daß die genannten Ausgangsmittel Decodiermittel (94) besitzen, die mit den genannten Adressiermitteln verbunden sind und auf das genannte Lesesignal und auf die genannten Adressensignale ansprechen, um ein Auslesesignal abzugeben, welches den Leitfähigkeitswert eines ausgewählten der genannten Transistoren darstellt, sowie Abfühmittel (SA12, SA23, SA34, 104) die auf das genannte Auslesesignal ansprechen und eine Gruppe von n Binärsignalen abgeben, welche den Wert des genannte Auslesesignals darstellen.

5. Nur-Lesen-Speicher nach Anspruch 4, bei dem die genannten Lesemittel s$^n$-1 Leseverstärker (SA12, SA23, SA34) besitzen, die geeignet sind, das Auslesesignal mit entsprechenden unterschiedlichen Bezugspegeln zu vergleichen und entsprechende Vergleichssignale abhängig von der relative Größe des genannten Auslesesignals und der genannte Bezugspegel abzugeben, sowie logische Mittel (104), die im Betrieb auf die genannten Vergleichssignale ansprechen, um die genannten n Binärsignale abzugeben.

6. Nur-Lesen-Speicher nach Anspruch 5, dadurch gekennzeichnet, daß die genannten Ausgangsmittel eine Decodiervorrichtung (105) besitzen, die mit den genannten Adressiermitteln gekoppelt ist und auf die genannten Adressiersignale anspricht, um ein Ausgangssignal entsprechend eines ausgewählten der genannten n Binärsignale abzugeben.

7. Nur-Lesen-Speicher nach einem der vorhergehenden Ansprüche, dadurch gekennzeichnet, daß das Lesesignal die Form eines Spannungssignals besitzt.

## Revendications

1. Mémoire morte comprenant des moyens d'adressage, plusieurs transistors à effet de champ disposés de façon à représenter une information numérique prédéterminée, et des moyens de sortie, caractérisée en ce que les canaux desdits transistors à effet de champ (111, 112, ...mk) ont des valeurs de conductance prédéterminées déterminées par des aires respectives prédéterminées de la section des canaux desits transistors (111, etc.) et choisies parmi au moins trois valeurs possibles de conductance, de manière qu'en réponse à des signaux d'adresse appliqués auxdits moyens d'adressage, le ou les transistors adressés produisent un signal de détection déterminé par la valeur ou les valeurs de conductance associées au ou aux transistors adressés, ledit signal de détection étant appliqué en fonctionnement auxdits moyens de sortie (94, SA12, etc., 104, 105).

2. Mémoire morte selon la revendication 1, caractérisé en ce que lesdites valeurs de conductance prédéterminées sont choisies parmi $2^n$ valeurs possibles de conductance (n>1).

3. Mémoire morte selon la revendication 2, caractérisée en ce que lesdits aires prédéterminées des sections sont déterminées par des largeurs respectives prédéterminées des canaux desdits transistors (111, etc.), lesdites largeurs de canaux correspondant aux largeurs de diffusions respectives de source et de drain desdits transistors.

4. Mémoire morte selon la revendication 3, caractérisée en ce que lesdits moyens de sortie comprennent: un moyen de décodage (94) couplé auxdits moyens d'adressage et réagissant audit signal de détection et auxdits signaux d'adressage en produisant un signal de lecture représentant la valeur de conductance de l'un, choisi, desdits transistors; et des moyens de détection (SA12, SA23, SA34, 104) réagissant audit signal de lecture en produisant un jeu de n signaux binaires représentant la valeur dudit signal de lecture.

5. Mémoire morte selon la revendication 4, dans laquelle lesdits moyens de détection comprennent $2^n$-1 amplificateurs de détection (SA12, SA23, SA34) conçus pour comparer ledit signal de lecture à des niveaux respectifs différents de référence et pour produire des signaux respectifs de comparaison suivant l'amplitude relative dudit signal de lecture et desdits niveaux de référence, et des moyens logiques (104) réagissant en fonctionnement auxdits signaux de comparaison en produisant lesdits n signaux binaires.

6. Mémoire morte selon la revendication 5, caractérisée en ce que lesdits moyens de sortie comprennent un dispositif de décodage (105) couplé auxdits moyens d'adressage et réagissant auxdits signaux d'adressage en produisant une sortie représentant l'un, choisi, desdits n signaux binaires.

7. Mémoire morte selon l'une quelconque des revendications précédentes, caractérisée en ce que ledit signal de détection se présente sous la forme d'un signal de tension.

FIG.1

0 020 648

## FIG. 2

## FIG. 3

## FIG. 4

FIG. 5

# FIG. 6

LOADS
&
PRECHARGES

$V_{SS}$

$V_{PRE}$

$I_{CS}$

$V_{CS}$

93

91

106

111 OR 112 OR ... mk

$X_i$

$V_{ROW}$

$V_{DD}$

$Y_j$

THROUGH Y DECODE
TO SENSE AMPLIFIERS

# FIG. 7

INCREASING MAGNITUDE

$V_{REFERENCE}$

$V_{OUT}$

$V_4$ (11)

$V_{34}$

$V_3$ (10)     $V_3 < V_{34} < V_4$

$V_{23}$

$V_2$ (01)     $V_2 < V_{23} < V_3$

$V_{12}$

$V_1$ (00)     $V_1 < V_{12} < V_2$